(19) Europäisches Patentamt
European Patent Office
Office européen des brevets

(11) Numéro de publication : **0 313 455 B1**

(12) **FASCICULE DE BREVET EUROPEEN**

(45) Date de publication du fascicule du brevet :
04.03.92 Bulletin 92/10

(51) Int. Cl.⁵ : **F24F 9/00, H01L 21/00**

(21) Numéro de dépôt : **88402626.1**

(22) Date de dépôt : **19.10.88**

(54) **Enceinte isolée vis à vis de la pollution extérieure.**

(30) Priorité : **20.10.87 FR 8714469**

(43) Date de publication de la demande :
**26.04.89 Bulletin 89/17**

(45) Mention de la délivrance du brevet :
**04.03.92 Bulletin 92/10**

(84) Etats contractants désignés :
**BE CH DE ES GB GR IT LI LU NL SE**

(56) Documents cités :
**EP-A- 0 058 782**
**EP-A- 0 099 818**
**EP-A- 0 273 791**
**DE-B- 1 106 473**
**FR-A- 2 087 023**
**FR-A- 2 191 944**

(56) Documents cités :
**FR-A- 2 343 206**
**FR-A- 2 515 319**
**US-A- 3 223 396**
**US-A- 4 162 196**
**US-A- 4 696 226**

(73) Titulaire : **SOCIETE GENERALE POUR LES TECHNIQUES NOUVELLES S.G.N. Société anonyme dite:**
**1, rue des Hérons Montigny-le-Bretonneux**
**F-78184 Saint-Quentin-en-Yvelines Cédex (FR)**

(72) Inventeur : **Meline, François**
**43 rue St. Placide**
**F-75006 Paris (FR)**

(74) Mandataire : **Le Roux, Martine et al**
**Cabinet Beau de Loménie 55, rue d'Amsterdam**
**F-75008 Paris (FR)**

**Description**

Une tranche de matériau semi-conducteur (silicium monocristallin par exemple) est soumise à de multiples traitements physicochimiques avant de devenir un composant électronique (transistor, circuit intégré, etc.).

Ces traitements se font dans des enceintes fermées pour permettre d'opérer en atmosphère strictement contrôlée et en particulier sans poussière.

Il faut pouvoir transférer des "pièces" d'une enceinte à l'autre sans rupture du confinement et sans risque de contamination au moyen d'une enceinte mobile.

On se place facilement en atmosphère contrôlée en utilisant des portes étanches (par serrage de joint)(voir par exemple US-A-4162196).

On transfère facilement d'une enceinte fixe à une enceinte mobile après un accostage avec verrouillage, serrage de joints et ouverture des portes de séparation.

L'expérience montre que toutes les solutions mécaniques sont bonnes pour rester en atmosphère contrôlée, mais désastreuses pour la pollution par les poussières.

En effet, toute porte étanche présuppose écrasement de joint, frottements, serrage mécanique, toutes ces opérations engendrant des poussières. L'ouverture des portes après accostage est une opération encore plus pernicieuse puisque l'extérieur de la porte se trouve, par ouverture, dans l'enceinte.

La présente invention résout le problème de l'atmosphère contrôlée par une fermeture dynamique et le problème des poussières par la suppression de toute pièce mécanique telle que joints de portes, verrou, etc, par une enceinte comprenant les caractéristiques de la revendication 1.

Une caractéristique principale de l'invention est d'opérer sur une enceinte en légère surpression comportant une ouverture à l'extrémité d'un élément tubulaire abouché sur l'enceinte.

La légère surpression crée un courant gazeux à travers l'ouverture; comme on veut limiter la vitesse de ce courant, il est conseillé d'opérer à des surpressions inférieures à 10 pascals (équivalant à un millimètre de colonne d'eau).

Une fente (ou plusieurs) sur l'élément tubulaire au voisinage de l'ouverture permet d'insuffler un gaz de façon à fournir une nappe continue séparant l'enceinte de l'extérieur.

Une autre caractéristique importante de l'invention est d'insuffler un courant gazeux faible (en débit par rapport au débit insufflé par la fente) par une plaque frittée (ou plusieurs) située entre la fente et l'ouverture de la partie tubulaire.

Pour la description, on se reportera aux figures qui accompagnent le texte :

– la figure 1 représente en perspective une enceinte et un prolongement tubulaire de section rectangulaire,

– la figure 2 représente en perspective une enceinte et un prolongement tubulaire de section circulaire,

– la figure 3 représente en coupe le principe de création des nappes continues,

– la figure 4 représente en perspective les nappes continues dans le cas d'un tube rectangulaire,

– la figure 5 représente en coupe le détail d'une fente,

– la figure 6 représente en perspective l'accostage sans contact,

– la figure 7 représente en section la déformation des nappes à l'accostage,

– la figure 8 représente en perspective, partiellement coupée,la nappe unique issue d'une fente continue dans le cas d'un tube circulaire.

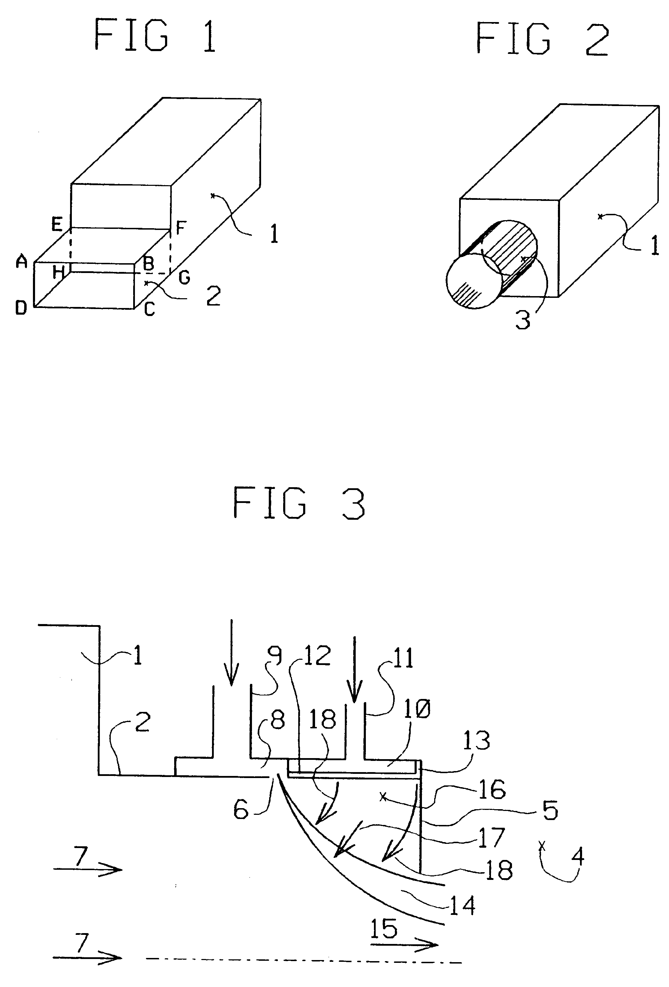

Une enceinte 1 en surpression par rapport à l'extérieur est munie d'une prolongation tubulaire de section rectangulaire (repère 2) ou circulaire (repère 3 de la figure 2).

Cette prolongation sera dénommée "tube" par la suite.

La face avant du tube est ouverte : sur la figure 1, la face ABCD est une ouverture démunie de porte.

Pour simplifier, on décrit en détail l'organisation intérieure du tube dans le cas rectangulaire et on indiquera ensuite les points particuliers de l'organisation intérieure du tube circulaire.

Le principe de l'invention consiste à remplacer une porte matérielle par une ou plusieurs nappes gazeuses continues, comme montré sur la figure 3.

L'enceinte 1 est en surpression par rapport à l'atmosphère extérieure 4, ce qui se traduit par un courant gazeux régulier 7 entrant dans le tube 2.

Sur deux faces opposées du tube 2, près de l'ouverture 5, est prévue une fente 6, parallèle à l'arête AB (figure 1) et occupant toute la largeur intérieure du tube; la fente débouche à l'intérieur du tube 2.

Dans le cas de la figure 1, il y a donc une fente sur la face ABFE et une fente sur la face DCGH, ces feux fentes étant toutes deux parallèles à AB.

On a choisi les faces définies ci-dessus pour les fentes parce qu'il est plus avantageux de les placer sur les grandes faces.

La position verticale, ou horizontale, des faces n'a pas d'importance, comme le démontre à l'évidence la possibilité d'opérer sur un tube circulaire.

Sur chacune des faces correspondantes, la fente 6 est alimentée en gaz par une chambre 8 munie d'une arrivée de gaz 9. Entre la fente et l'arête du tube (AB par exemple), une deuxième chambre 10 (munie d'une arrivée de gaz 11) est prévue sur chacune des faces munies d'une fente.

La chambre 10 est "fermée" du côté intérieur du tube 2 par une plaque de matière poreuse 12. Il est avantageux de fermer également la chambre 10 du côté de l'ouverture du tube par une plaque poreuse 13. On peut également utiliser une plaque usinée pour réunir en une seule pièce 12 et 13.

Le fonctionnement est le suivant : le débit gazeux 7 recourbe la nappe 14 sortant de la fente 6. Une partie du débit 7 entre dans la nappe 14, une autre partie sort parallèlement au plan médian suivant la flèche 15.

La zone 16 entre la nappe 14 et la face intérieure du tube est en dépression, car le jet 14 aspire latéralement le gaz l'entourant (suivant une flèche telle que 17).

La dépression de la zone 16 se traduirait par une entrée d'air extérieur dans le tube 2, d'où risque de pollution.

Pour minimiser ou même annuler cette dépression, on insuffle un léger débit gazeux 18 à travers les plaques poreuses 12 et 13. On ajuste le débit de l'arrivée 11 pour supprimer cette dépression.

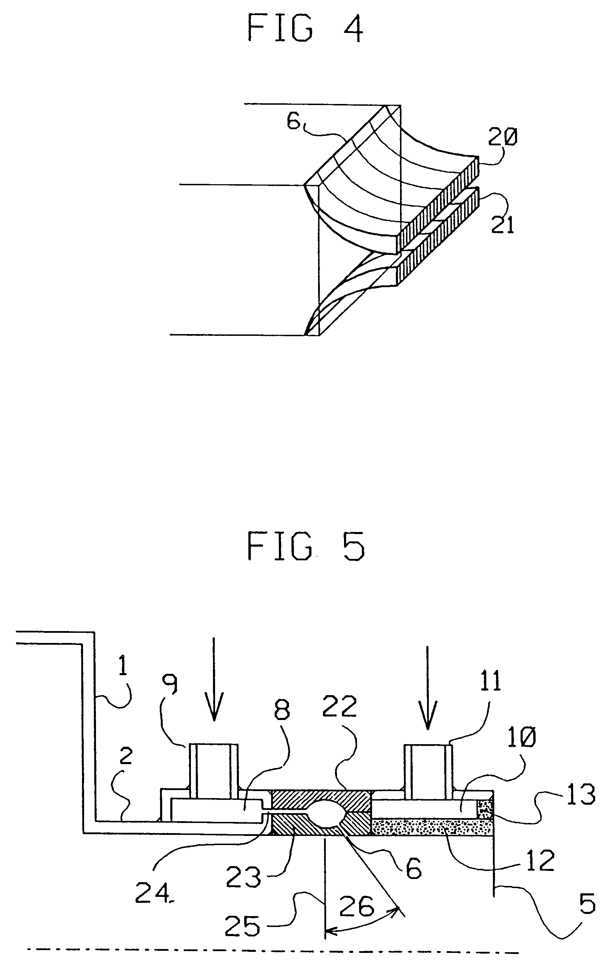

La figure 4 montre la forme des deux nappes continues 20 et 21 sortant des deux fentes opposées (telles que 6).

Pour simplifier le dessin, la figure 4 ne comporte qu'un cadre schématisant le tube 2.

Il ne faut pas oublier que tout l'espace entre les deux nappes 20 et 21 est rempli par le courant 15 provenant de la surpression de l'enceinte et entrant dans le tube 2 suivant les flèches 7.

La surface entière de l'ouverture est traversée en tout point par un ou plusieurs flux gazeux. Il n'existe pas de zone de l'ouverture, même au voisinage des arêtes, quine soit pas traversée par un ou plusieurs flux. Il s'ensuit qu'il n'y a pas possibilité d'entrée d'air, de poussière, etc., de l'extérieur vers l'intérieur.

La figure 5 montre une réalisation détaillée d'une partie d'une face du tube 2 proche de l'ouverture 5. On retrouve la chambre 8 et l'arrivée de gaz 9 communiquant avec la fente 6 par l'espace 24 ménagé entre les pièces 22 et 23.

La fente 6 est usinée dans la pièce 23 obliquement vers l'ouverture extérieure du tube.

On utilise généralement une valeur proche de 30 degrés pour l'angle 26 avec la normale 25 à la paroi.

On voit également la chambre 10 et son arrivée de gaz 11 et les plaques poreuses 12 et 13.

La plaque 12 ferme la chambre 10 du côté intérieur du tube 2; la plaque 13 ferme la chambre 10 sur la face de sortie du tube 2 (face ABCD de la figure 1). Il peut être utile que la plaque 13 fasse légèrement saillie à l'extérieur du tube. De cette manière, le courant d'air sortant à travers 13 a pour effet de maintenir propre la face extérieure de la plaque 13.

Suivant la nature du milieu poreux, les pièces 12 et 13 seront deux pièces distinctes ou deux parties d'une même pièce.

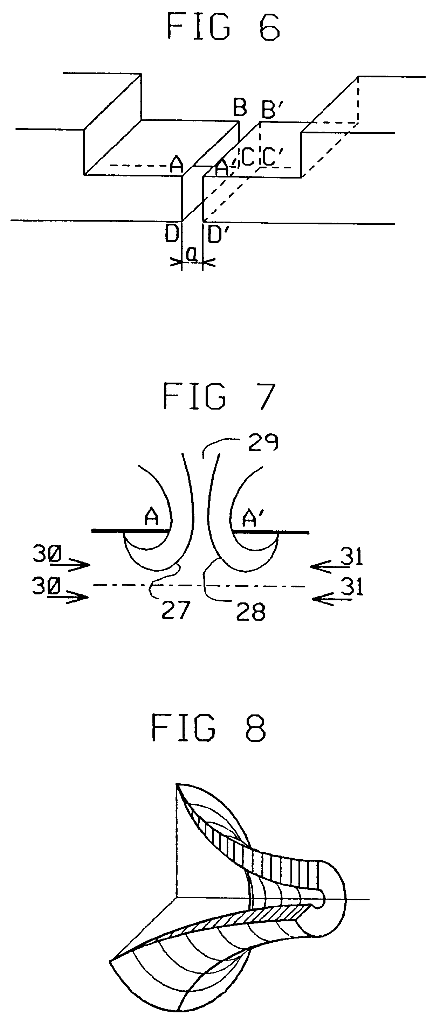

Quand on rapproche deux enceintes comme sur la figure 6, on met exactement en prolongement face à face les tubes de chacune des enceintes. Il est évident que les tubes doivent avoir strictement les mêmes dimensions et la même forme géométrique. En outre, les faces ABCD et A'B'C'D' doivent être parallèles.

La distance A entre ces faces doit être respectée soigneusement : le procédé n'a toute son efficacité que pour $a < a_0$ ($a_0$ valeur maximale de cette distance a).

La distance "a" règle la section de passage pour la totalité des gaz issus des deux enceintes et règle donc la vitesse desdits gaz.

L'expérience montrant que cette vitesse doit être supérieure à $V_0$, on calculera facilement la valeur de $a_0$ correspondante. En appelant Q le débit total de tous les gaz sortant de l'ensemble des deux enceintes et des deux tubes et p le périmètre d'un tube, on a, en unités cohérentes, $a_0 = Q/p\ V_0$.

Le rapprochement des tubes des deux enceintes déforme les jets gazeux, comme le montre la figure 7.

L'espace entre AB et A'B' est entièrement rempli par la coopération de trois nappes gazeuses :

– la nappe 27 provenant de la fente supérieure de l'enceinte de gauche,

– la nappe 28 provenant de la fente supérieure de l'enceinte de droite,

– la nappe 29 composée de la réunion des débits de droite et de gauche créés par la surpression dans chacune des enceintes (courant marqué par la flèche 7).

Les nappes 27 et 28 sont recourbées par la nappe 29 et sont au plus tangentes pour laisser passer entre elles ladite nappe 29.

Le raisonnement est exactement le même pour la zone CD C'D.

Pour la zone AA'DD', elle est barrée par un "mur" constitué par les faces latérales des courants 27, 28 et 29.

Le même raisonnement s'applique à BB'CC'.

On voit donc que les quatre faces libres (telles que AB B'A') sont entièrement protégées et qu'aucun gaz ou corpuscule ne peut entrer à travers les divers courants à l'intérieur d'un tube et encore moins de l'enceinte.

Il est possible, au moment de l'accostage, de diminuer les débits gazeux de l'une ou des deux enceintes pour diminuer la vitesse de sortie dans l'intervalle entre les enceintes. En particulier, quand les enceintes sont placées toutes deux dans une ambiance où les mouvements de convection sont faibles, il n'est pas utile d'assurer une grande vitesse de sortie.

Le raisonnement s'applique dans les deux sens : si on considère une enceinte isolée, à l'arrêt, l'ensemble des débits sortants donne une vitesse de sortie Vs. Si on déplace l'enceinte à une vitesse v, on doit augmenter les débits pour augmenter Vs et compenser v.

Comme en général v est beaucoup plus petit que Vs, il suffira d'augmenter Vs de la valeur de v.

On remarque que la figure 7 représente en section les courants gazeux déformés à l'accostage, aussi bien pour un tube rectangulaire que pour un tube circulaire.

EXEMPLE DE REALISATION

Une enceinte se termine par un tube rectangulaire de section intérieure 172 x 200 mm$^2$.

Le débit dans le tube (flèche 7) est de 30 m$^3$/h; chaque fente, longue de 200 mm, large de 0,8 mm, est usinée dans une pièce 23 épaisse de 3 mm.

L'angle 26 entre la normale et l'axe de la fente est de 30°. Le débit d'air filtré dans l'arrivée 9 est réglé à 3,5 m$^3$/h pour chaque fente.

Les plaques de matière poreuse sont constituées d'un métal fritté de transparence 0,2 (sur une section perpendiculaire au sens de traversée, le rapport surface des pores coupés/surface totale est égal à 0,2). Chaque plaque 12 mesure 200 mm x 30 mm pour une épaisseur de 1 mm.

Chaque plaque 13 mesure 200 mm x 5 mm en épaisseur de 5 mm.

En fait, on a usiné en une seule pièce les pièces 12 et 13.

Par l'arrivée 11, on envoie dans chaque chambre 10 1 m$^3$/h d'air filtré.

Un accostage entre deux enceintes terminées par des tubes rectangulaires identiques de dimensions intérieures 172 mm x 200 mm doit se faire à une distance inférieure à a = 100 mm, ce qui assure une vitesse de sortie des gaz supérieure à 0,3 m/s.

L'exemple ne porte que sur un tube rectangulaire, mais la description permet de comprendre que le procédé s'applique aussi bien à un tube rectangulaire qu'à un tube circulaire. On peut bien entendu admettre une légère déformation elliptique dans le cas d'un tube circulaire ou un léger bombement des faces dans le cas d'un tube à section rectangulaire.

Il est également intéressant de noter que la nature et la qualité des différents gaz mis en oeuvre dans le procédé peuvent être différentes.

L'enceinte est en surpression d'un gaz $G_1$ qui arrive dans le tube suivant les flèches 7. Les fentes sont alimentées par un gaz $G_2$ amené par l'arrivée 9. Le débit à travers les milieux poreux (12-13) est assuré par le gaz $G_3$ amené dans la chambre 10 par l'arrivée 11.

Le choix de la nature et de la propreté du gaz $G_1$ dépend du traitement en cours dans l'enceinte et ne concerne donc pas le procédé objet de la présente invention.

En ce qui concerne les gaz $G_2$ et $G_3$, on peut généralement utiliser (pour l'un et l'autre) de l'air filtré. Il n'y a en effet aucune possibilité d'entrée des gaz des fentes ou des milieux poreux dans l'enceinte; en particulier, le courant 7 protège l'enceinte contre ce risque. Cela permet donc d'utiliser un gaz particulièrement économique, tel que l'air atmosphérique filtré pour assurer une part importante des débits gazeux.

Cette possibilité est particulièrement intéressante pour une enceinte mobile de transfert. Il ne s'y fait pas de traitement, on peut l'alimenter au moyen d'un ventilateur et de filtres se déplaçant avec l'enceinte.

**Revendications**

1. Enceinte (1) en légère surpression, isolable vis-à-vis de la pollution extérieure, munie d'un tube (2) dont une extrémité débouche dans ladite enceinte et dont l'autre extrémité (5) est ouverte, caractérisée en ce que sont aménagées :

   – sur la paroi intérieure dudit tube (2) et au voisinage de ladite ouverture (5) au moins une fente (6) disposée dans un plan perpendiculaire à l'axe dudit tube (2) et inclinée vers ladite ouverture (5) ; la(les)dite(s) fente(s) étant destinée(s) à être alimentée(s) par un gaz de façon à insuffler, dans ledit tube (2) une nappe continue dudit gaz ;

   – sur la paroi intérieure dudit tube (2) et entre la(les)dite(s) fente(s) (6) et ladite ouverture (5) au moins une plaque poreuse (12, 13) ; la(les)dite(s) plaque(s) poreuse(s) (12,13) étant destinée(s) à être alimentée(s) par un gaz de façon à générer un faible courant gazeux.

2. Enceinte selon la revendication 1, caractérisée en ce que le tube (2) a une section rectangulaire et en ce que sur chacune des deux faces opposées dudit tube est aménagée une fente (6), alimentée par une chambre (8), et en ce que chacune desdites fentes (6) occupe toute la longueur intérieur du tube.

3. Enceinte selon la revendication 2, caractérisée en ce que lesdites fentes (6) sont disposées sur les deux plus grandes faces du tube rectangulaire.

4. Enceinte selon la revendication 1, caractérisée en ce que le tube (2) a une section circulaire, en ce que la fente (6) est continue et fait le tour intérieur dudit tube (2), en ce qu'une chambre (8) alimentant en gaz ladite fente (6) fait le tour extérieur dudit tube (2), en ce qu'une plaque poreuse (12) fait également le tour intérieur dudit tube (2), en ce qu'une seconde plaque poreuse (13) forme une bordure continue à l'ouverture (5) et en ce qu'une chambre (10), faisant le tour dudit tube (2), alimente en gaz lesdites plaques poreuses (12,13).

5. Procédé d'isolement d'une enceinte selon l'une quelconque des revendications 1 à 4, caractérisé en ce qu'il consiste :

   – à alimenter la(les)dite(s) fente(s) (6) à l'aide d'un gaz, de façon à insuffler dans ledit tube (2) une nappe continue (14) dudit gaz ;

– à alimenter la(les)dite(s) plaque(s) poreuse(s) à l'aide d'un gaz formant un faible courant gazeux apte à supprimer la dépression formée par la nappe gazeuse (14) sortant de la(des) dite(s) fente(s) (6) ;

– à maintenir ladite enceinte (1) en légère surpression de façon à créer un courant gazeux (7) qui parcourt ledit tube (2) et inféchit vers l'ouverture (5) la (ou les) nappe(s) de gaz sortant de la (ou des)dite(s) fente(s) (6).

6. Procédé selon la revendication 5, caractérisé en ce que la vitesse du gaz sortant de la (ou des) fente(s) (6) est au moins dix fois la vitesse du gaz sortant de la (ou des) plaque(s) poreuse(s) (12,13).

7. Procédé selon l'une des revendications 5 ou 6, caractérisé en ce que la vitesse de sortie des gaz par l'ouverture (5) est augmentée, quand on déplace l'enceinte (1), pour compenser la vitesse de déplacement.

8. Procédé selon l'une quelconque des revendications 5 à 7, caractérisé en ce que la surpression dans l'enceinte (1) est créée en insufflant un gaz de haute pureté et que l'alimentation des fentes (6) et des plaques poreuses (12,13) est faite par de l'air filtré.

9. Procédé selon l'une quelconque des revendications 5 à 8, caractérisé en ce que lors d'un accostage entre deux enceintes munies de tubes identiques on règle la distance d'accostage de manière que la vitesse de sortie de l'ensemble des gaz des deux enceintes soit comprise entre 0,3 et 0,6 m/s pour une atmosphère ambiante calme et que l'on réduit autant que faire se peut également les débits dans les deux enceintes si l'exigence de vitesse de sortie des gaz est difficile à atteindre.

**Patentansprüche**

1. Unter leichtem Überdruck stehender Raum (1), der gegenüber äußerer Verunreinigung isolierbar ist, versehen mit einem Rohr (2), von dem ein Ende in den Raum mündet und dessen anderes Ende (5) offen ist, **dadurch gekennzeichnet,** daß vorgesehen sind:

– auf der inneren Seitenwand des Rohrs (2) und in der Nähe der Öffnung (5) wenigstens ein Spalt (6), der in einer Ebene senkrecht zur Achse des Rohrs (2) angeordnet ist und zur Öffnung (5) hin geneigt ist; wobei der(die) Spalt(e) dazu bestimmt ist(sind), mit einem Gas gespeist zu werden, derart, daß in das Rohr (2) eine kontinuierliche Gasschicht eingeblasen wird;

– auf der inneren Seitenwand des Rohres (2) und zwischen der(den) Kerbe(n) (6) und der Öffnung (5) wenigstens eine poröse Platte (12,13); wobei die poröse Platte(n) (12,13) dazu bestimmt ist(sind), mit einem Gas versorgt zu werden, derart, daß ein schwacher Gasstrom erzeugt wird.

2. Raum nach Anspruch 1, **dadurch gekennzeichnet,** daß das Rohr (2) einen rechteckigen Querschnitt aufweist und daß auf einer jeden der gegenüberliegenden Seiten des Rohres ein Spalt (6) ausgebildet ist, der von einer Kammer (8) gespeist wird, und daß eine jede der Spalten (6) die gesamte innere Länge des Rohres besitzt.

3. Raum nach Anspruch 2, **dadurch gekennzeichnet,** daß die Spalte (6) an den beiden längsten Seiten des rechteckförmigen Rohres angeordnet ist.

4. Raum nach Anspruch 1, **dadurch gekennzeichnet,** daß das Rohr (2) einen kreisförmigen Querschnitt aufweist und daß der Spalt (6) kontinuierlich ist und im Inneren des Rohrs (2) herumgeht, daß eine Kammer (8), die den Spalt (6) mit Gas versorgt, außen herum um das Rohr (2) geht, daß eine poröse Platte (12) ebenfalls innen herum im Rohr (2) geht, daß eine zweite poröse Platte (13) einen kontinuierlichen Rand zur Öffnung (5) bildet, und daß eine Kammer (10), die um das Rohr (2) herumgeht, die porösen Platten (12,13) mit Gas versorgt.

5. Verfahren zum Isolieren eines Raumes nach einem der Ansprüche 1 bis 4, **dadurch gekennzeichnet,** daß es besteht aus :

– Versorgen des(der) Spalts(Spalte) (6) mit Hilfe eines Gases, derart, daß eine kontinuierliche Schicht (14) des Gases in das Rohr (2) eingeblasen wird;

– Versorgen der porösen Platte(n) mit Hilfe eines Gases, wobei ein schwacher Gasstrom gebildet wird, der in der alge ist, den durch die Gasschicht (14), die den(die) Spalt(e) (6) verläßt, gebildeten Unterdruck wegzunehmen;

– Beibehalten des Raumes (1) in leichtem Überdruck derart, daß ein Gasstrom (7) erzeugt wird, der durch das Rohr (2) läuft und sich zur Öffnung (5) biegt, wobei die Gasschicht(en) den (oder die) Spalt(e) (6) verlassen.

6. Verfahren nach Anspruch 5, **dadurch gekennzeichnet,** daß die Geschwindigkeit des den (oder die) Spalt(e) (6) verlassendes Gas wenigstens zehnmal größer ist als die Gechwindigkeit des Gases, das die poröse(n) Platte(n) (12,13) verläßt.

7. Verfahren nach einem der Ansprüche 5 oder 6, **dadurch gekennzeichnet,** daß die Austrittsgeschwindigkeit des Gases durch die Öffnung (5) erhöht ist, wenn der Raum (1) bewegt wird, um die Bewegungsgeschwindigkeit zu kompensieren.

8. Verfahren nach einem der Ansprüche 5 bis 7, **dadurch gekennzeichnet,** daß der Überdruck im Raum (1) erzeugt wird durch Einblasen von Gas hoher Reinheit, und daß die Versorgung der Spalte (6) und der porösen Platten (12, 13) durch gefilterte Luft erfolgt.

9. Verfahen nach einem der Ansprüche 5 bis 8, **dadurch gekennzeichnet,** daß beim Zusammenfügen von zwei mit identischen Rohren versehenen Räumen der Verbindungsabstand derart eingestellt wird, daß die Austrittsgeschwindigkeit der Gesamtheit der Gase der beiden Räume zwischen 0,3 und 0,6 m/s für eine ruhige Umgebungsatmosphäre ist und daß so weit wie möglich ebenfalls die Durchsätze reduziert werden in den beiden Räumen, wenn die geforderte Austrittsgeschwindigkeit der Gase schwer zu erreichen ist.

**Claims**

1. Slightly pressurized enclosure (1), which can be isolated from external pollution, provided with a tube (2) having one end opening out into said enclosure and having its other end (5) open, characterized in that it comprises:
  - at least one slot (6) provided in the inside wall of said tube (2) and in the vicinity of said open end (5), said slot being disposed in a plane perpendicular to the axis of said tube (2) and sloping towards said opening (5), said slot or slots being designed to be fed with gas so as to blow a continuous sheet of said gas into said tube (2);
  - at least one porous plate (12,13) disposed on the inside wall of said tube (2) and between said slot or slots (6) and said open end (5), said porous plate or plates (12,13) being designed to be fed with a gas so as to form a small flow of gas.

2. Enclosure according to claim 1, characterized in that the tube (2) is rectangular in section and in that each of two opposite faces of said tube has a slot (6) disposed therein and fed from a chamber (8), each of said slots (6) occupying the entire inside width of the tube.

3. Enclosure according to claim 2, characterized in that said slots (6) are disposed on the two bigger faces of the rectangular tube.

4. Enclosure according to claim 1, characterized in that the tube (2) is circular in section, in that the slot (6) is continuous and goes all the way round the inside of the tube (2), in that a chamber (8) feeding said slot (6) with gas surrounds the outside of said tube (2), in that a porous plate (12) also goes round the inside of said tube (2), in that a second porous plate (13) forms a continuous margin around the opening (5), and in that a chamber (10), going all round said tube (2) feeds said porous plates (12,13) with gas.

5. Method of isolating an enclosure according to any one of claims 1 to 4, characterized in that it consists in:
  - feeding said slot or slots (6) with a gas, so as to blow into said tube (2) a continuous sheet (14) of said gas;
  - feeding said porous plate or plates with a gas forming a small flow of gas suitable for overcoming the pressure reduction formed by the sheet of gas (14) leaving from said slot or slots (6):

  - maintaining said enclosure (1) at a slight excess pressure so as to create a gas flow (7) running through said tube (2) and deflecting towards the opening (5) the sheet or sheets of gas leaving said slot or slots (6).

6. Method according to claim 5, characterized in that the speed of the gas leaving the slot or slots (6) is at least ten times the speed of the gas leaving the porous plate or plates (12,13).

7. Method according to one of claims 5 or 6, characterized in that the gas outlet speed via the opening (5) is increased when the enclosure (1) is displaced in order to compensate for the speed of displacement.

8. Method according to any one of claims 5 to 7, characterized in that the excess pressure inside the enclosure (1) is created by blowing in a highly pure gas, and that the slots (6) and the porous plates (12,13) are fed with filtered air.

9. Method according to any one of claims 5 to 8, characterized in that during docking between two enclosures equipped with identical tubes, the docking distance is adjusted in such a manner that the outlet speed of all of the gases leaving the two enclosures lies between 0.3 m/s and 0.6 m/s for an ambient atmosphere which is calm, and in that the gas flow in the two enclosures are reduced as much as possible if the gas outlet speed requirement is difficult to achieve.

# FIG 1

# FIG 2

# FIG 3

# FIG 4

# FIG 5

# FIG 6

# FIG 7

# FIG 8

9